# EUROPEAN PATENT APPLICATION

(11) **EP 4 498 767 A1**
(43) Date of publication of application: **29.01.2025**
(21) Application number: 24190960.5
(22) Date of filing: 25.07.2024
(51) Int. Cl.: H05K 1/11, H05K 3/40, H05K 3/42, H05K 3/44, H05K 3/46, H05K 1/14, H05K 1/02

(54) **STIFFENER MEMBER WITH ONE OR MORE VIAS**

(30) Priority: 27.07.2023 US 202318360522
(71) Applicant: Avago Technologies International Sales Pte. Limited, Singapore 768923 (SG)
(72) Inventor: Dauksher, Walter, Fort Collins, 80525 (US); Wang, Tao, San Jose, 95134 (US); Hinton, Mark Andrew, Timnath, 80547 (US)
(74) Representative: Dilg, Haeusler, Schindelmann Patentanwaltsgesellschaft mbH

(57) **Abstract**

Novel tools and techniques are provided for implementing a semiconductor package or a chip package, and more particularly methods, systems, and apparatuses (100) are provided for implementing a semiconductor package or a chip package including a stiffener member (130) with a via (135). In various embodiments, an apparatus (100) includes a substrate (105) and a connector (110) electrically coupled to the substrate (105). A stiffener member (130) is disposed between the substrate (105) and the connector (110) and configured to restrain at least one of the substrate (105) or the connector (110). A via (135) extends through a body of the stiffener member (130) and electrically couples the connector (110) to the substrate (105).

## Description

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for implementing a semiconductor package or a chip package, and more particularly to methods, systems, and apparatuses for implementing a semiconductor package or a chip package including a stiffener member with one or more vias.

### BACKGROUND

Traditional stiffener rings are purely mechanical and do not include any electrical features. As more connectors and connections are added to chip packages, the mechanical stiffener ring competes for space with the connectors and connections in the chip packages. Once the connectors and connections are added to the chip packages there is little to no space left for a mechanical stiffener ring. However, without a stiffener ring, chip package warpage can be high due to a coefficient of thermal expansion mismatch between a substrate and circuit board.

Hence, there is a need for more robust and scalable solutions for implementing semiconductor packages and chip packages. Thus, methods, systems, and apparatuses for implementing semiconductor packages or chip packages including a stiffener member with one or more vias.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
FIGS. 1A, 1C, and 1E-1J are schematic cross-sectional views of a semiconductor device with a member comprising one or more vias, in accordance with various embodiments;
FIGS. 1B and 1D are top-front perspective views of a member comprising one or more vias, in accordance with various embodiments;
FIGS. 2A-2F are schematic cross-sectional views of a semiconductor device with a member comprising one or more vias, in accordance with various embodiments;
FIG. 3 is a schematic cross-sectional view of a semiconductor device with a member comprising one or more vias, in accordance with various embodiments; and
Fig. 4 is a flow diagram of a method of manufacturing a semiconductor device with a member comprising one or more vias, in accordance with various embodiments.

### DETAILED DESCRIPTION OF EMBODIMENTS

Various embodiments provide tools and techniques for implementing semiconductor packages or chip packages including a stiffener member with one or more vias.

In a first aspect, an apparatus including a substrate is provided. A connector is coupled to the substrate. A member is disposed between the substrate and the connector. The member restrains at least one of the substrate or the connector. Additionally, a via extends through a body of the member. The via couples to the connector and to the substrate.

In some embodiments, an area of a first surface of the member adjacent to a first surface of the substrate is characterized by about a same area size as an area of the first surface of the substrate. The member is configured to uniformly restrain the substrate across the area of the first surface of the substrate. In other cases, an area of a first surface of the member adjacent to a first surface of the substrate is smaller than a second surface of the member adjacent to a first surface of the connector.

In various instances, the connector comprises a printed circuit board. An area of a second surface of the member adjacent to a first surface of the printed circuit board is characterized by about a same area size as an area of the first surface of the printed circuit board.

In some embodiments, the connector comprises at least one of an optical connector, a high-speed data connector, a high-power connector, or a backplane connector, or the like. An area of a second surface of the member adjacent to a first surface of at least one of the optical connector, the high speed data connector, the high power connector, or the backplane connector is characterized by about a same area size or larger area size as an area of the first surface of at least one of the optical connector, the high speed data connector, the high power connector, or the backplane connector.

In various cases, the member has about a same coefficient of thermal expansion as the substrate. The member comprises at least one of copper, aluminum, ceramic, steel, stainless steel, Teflon, silicon, or polymer, and the via comprises at least one of copper, aluminum, gold, silver, tin, nickel, or lead. The member comprises at least two adjacent vias. A ratio between a distance between the at least two adjacent vias and a width of each via of the at least two adjacent vias is at least 2:1. A ratio between a length of the member and a thickness of the member is equal or greater than 10:1.

In another aspect, a semiconductor device comprises a substrate comprising an interconnect, a connector configured to couple to the interconnect of the substrate, and a member between the substrate and the connector. The member is configured to restrain at least one of the substrate or the connector. A via extends through the member and couples the interconnect of the substrate to the connector.

In some instances, a first surface of the member adjacent to a first surface of the substrate uniformly restrains the substrate across the first surface of the substrate. In some instances, an area of a first surface of the member adjacent to a first surface of the substrate is larger than an area of the first surface of the substrate.

In various embodiments, the connector comprises a printed circuit board. A second surface of the member adjacent to a first surface of the printed circuit board uniformly restrains the printed circuit board across the first surface of the printed circuit board. In other cases, the connector comprises at least one of an optical connector, a high-speed data connector, a high-power connector, or a backplane connector, or the like.

In some cases, the via is located in a first layer of the member, and the member further comprises a second redistribution layer electrically coupled to the via.

In yet another aspect, a method of manufacturing a semiconductor with a member is provided. The method includes providing a substrate and a connector. The method continues with coupling a member to the substrate and the connector. The member is between the substrate and the connector. The via extends through the member and electrically couples the substrate to the connector.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." The term "substantially" or "about" used herein refers to variations from the reference value or ratio of ± 10% or less (e.g., ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of' preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In conventional semiconductor or chip packages, stiffener rings are purely mechanical with no electrical features. However, as chip packages become more complex, the stiffener ring competes for space with connectors within the chip package.

The proposed embodiments may be a semiconductor or chip module (e.g., integrated circuit (IC), chip, or other semiconductor device) that provides a stiffener member with one or more vias. By implementing a stiffener member with one or more vias, the stiffener member can be configured to provide one or more electrical connections between the one or more connectors and a substrate of the semiconductor or chip module. Thus, this improved stiffener member provides electrical connections between the substrate and the one or more connectors while still controlling warpage between the substrate and the one or more connectors.

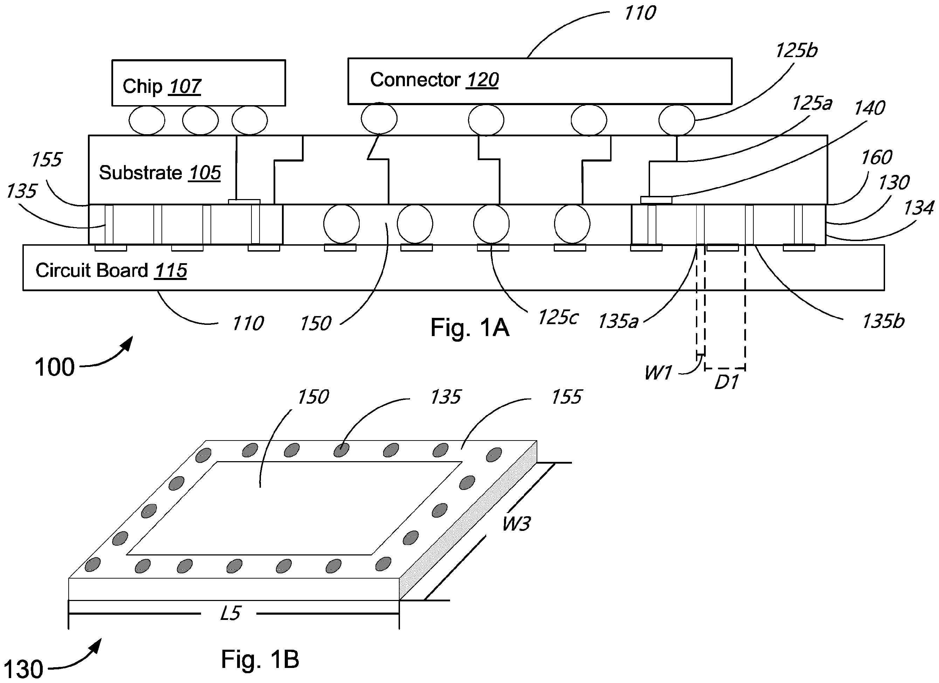

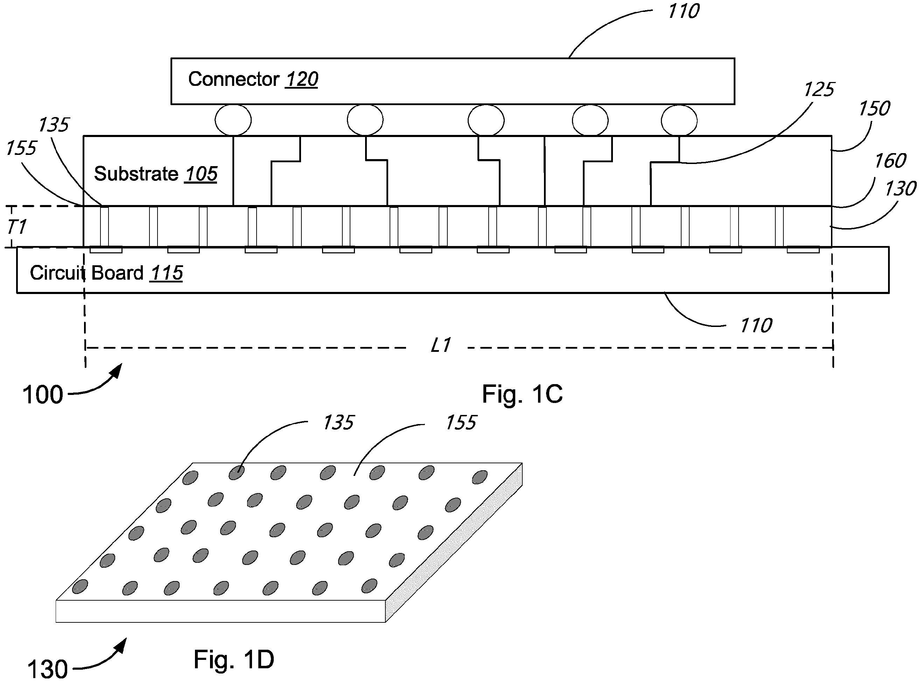

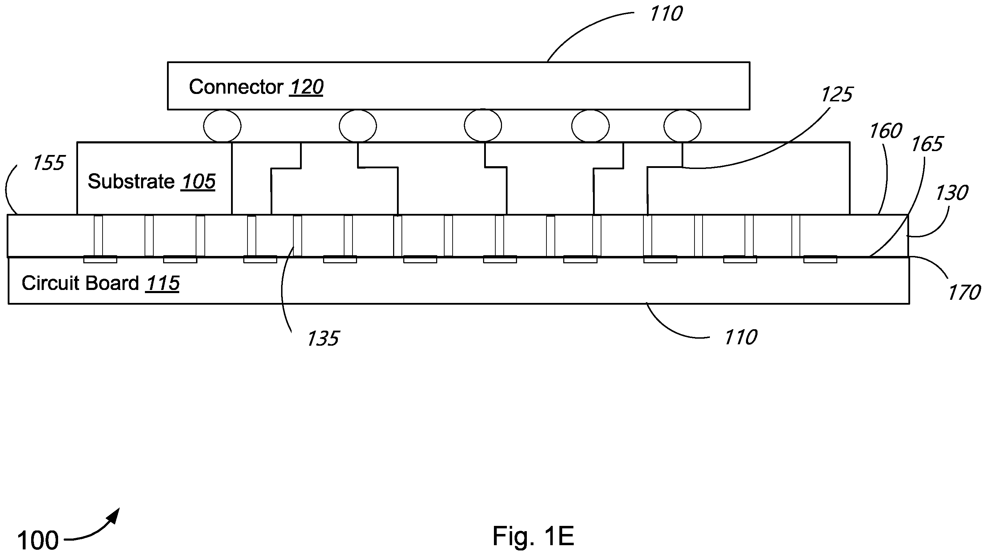

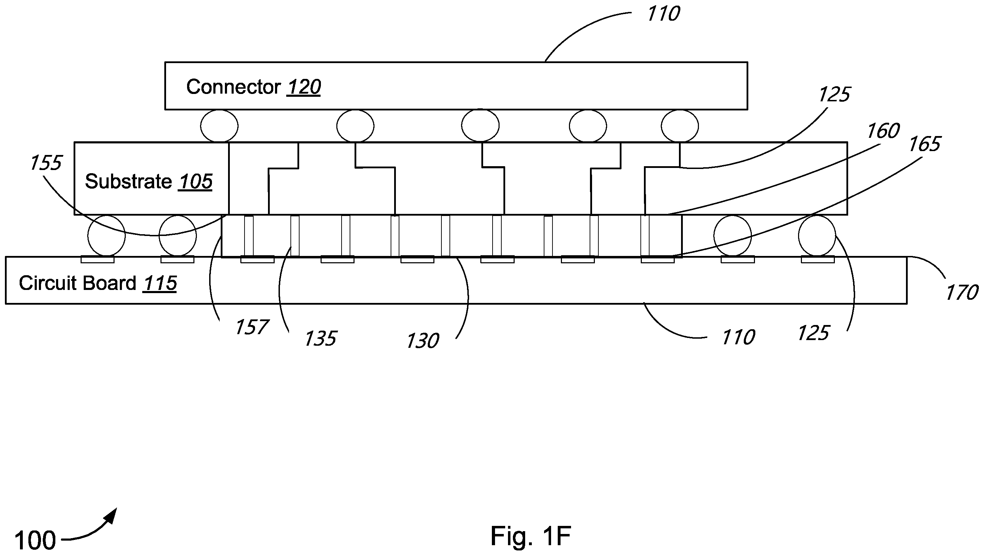

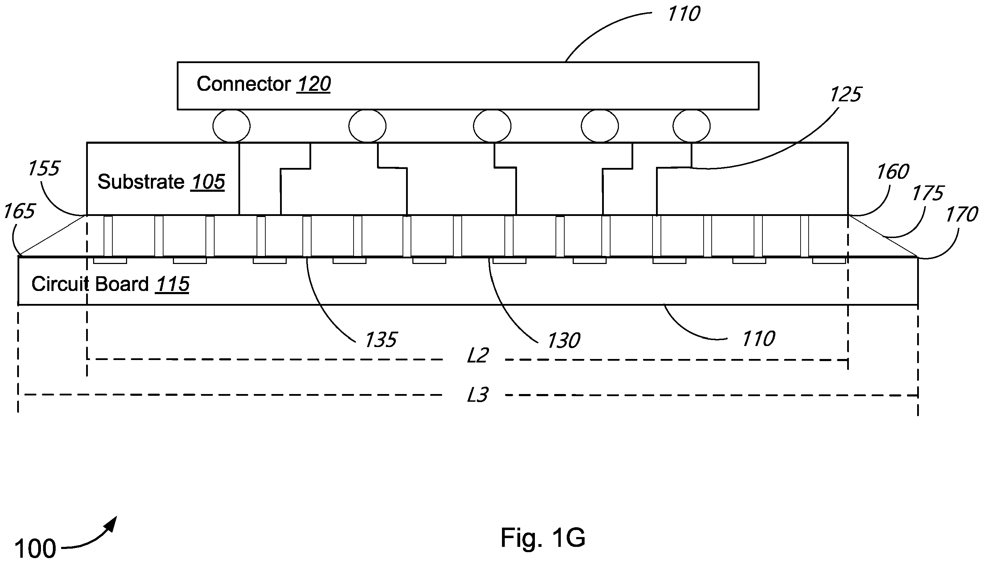

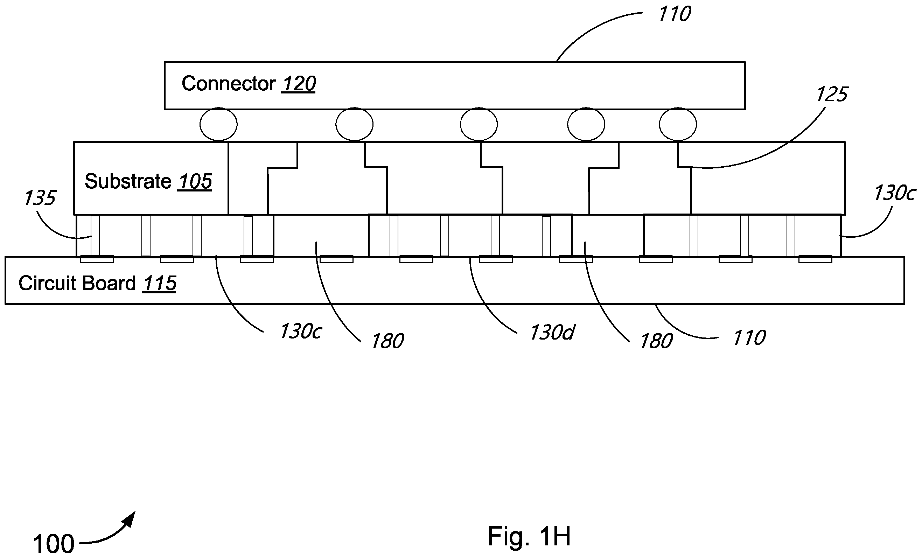

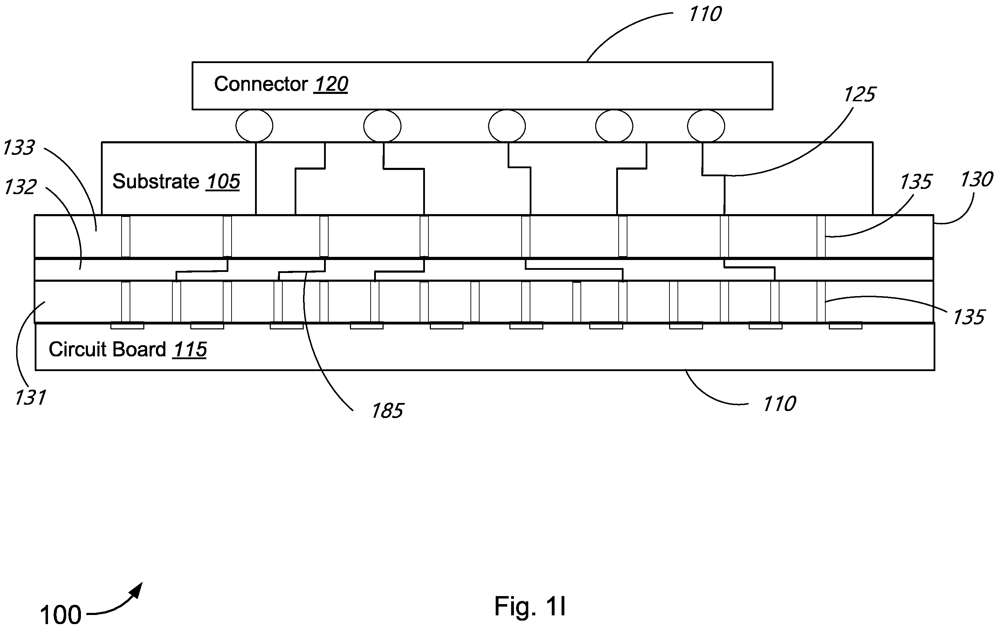

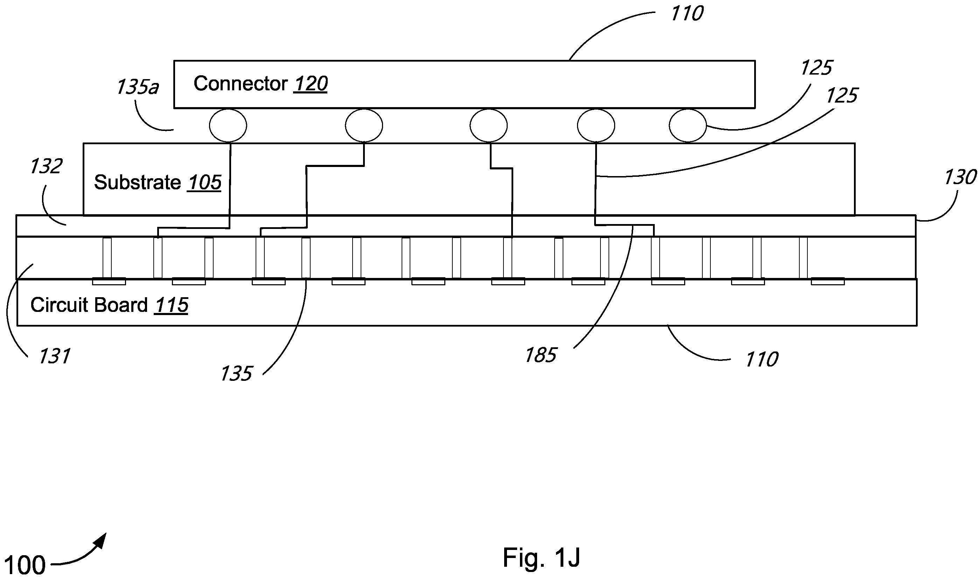

FIGS. 1A, 1C, and 1E-3 are schematic cross-sectional views of different embodiments of a semiconductor device 100, in accordance with various embodiments. FIGS. 1B and 1D are top-front perspective views of a member 130, in accordance with various embodiments. It should be noted that the various components of semiconductor device 100 are schematically illustrated in FIGS. 1-3, and that modifications to the various components, orientations, and other arrangements of semiconductor device 100 may be possible and in accordance with the various embodiments. In addition, although Figs. 1-3 are described as separate embodiments for ease of description, a person of ordinary skill would understand that various modifications to each embodiment may be applied to other embodiments.

In various embodiments, the semiconductor device 100 includes a substrate 105. The substrate 105 is a supporting material (e.g., silicon, silicon dioxide, aluminum oxide, gallium, germanium, ceramics, organic structures, laminated organic structures, and/or any other material or combination of materials) upon which or within which elements or components (e.g., connectors 110, member 130, interconnects 125, or the like) of a semiconductor device 100 are fabricated or attached.

In some instances, the semiconductor device 100 includes one or more connectors 110. The one or more connectors 110 are one or more elements, components, accessories, mechanisms, devices, or the like capable of being connected (e.g., electrically coupled, attached, or the like) to the substrate 105. In some cases, the one or more connectors 110 comprise a circuit board 115 (e.g., a printed circuit board (PCB)). Additionally or alternatively, the one or more connectors 110 (e.g., one or more connectors 120) comprise at least one of an optical connector, a high speed data connector, a high power connector, a backplane connector, or the like.

In various cases, the substrate 105 includes one or more layers. The layers can include one or more power planes, ground planes, other electrically conductive interconnect layers, non-conductive layers, redistribution layers, conductive structures, and other layers and structures. The layers may further include one or more layers configured to provide component interconnections. For example, routing layers are layers of the substrate 105 through which interconnections may be established between components of the semiconductor device 100. In a non-limiting example, the interconnections may be configured to connect (e.g., electrically connect) one or more connectors 120 to the circuit board 115. Connections may be routed, for example, through the substrate 105 via one or more interconnects 125. The interconnects 125 are one or more structures that couple (e.g., electrically couple or the like) two or more elements (e.g., substrate 105, connectors 110, member 130, or the like together) of the semiconductor device together. The interconnects 125 may include one or more copper or metal pads, copper or metal traces, copper or metal through-hole vias, copper or metal micro bumps, copper or metal solder balls, copper or metal posts or pillars, and/or other suitable interconnects.

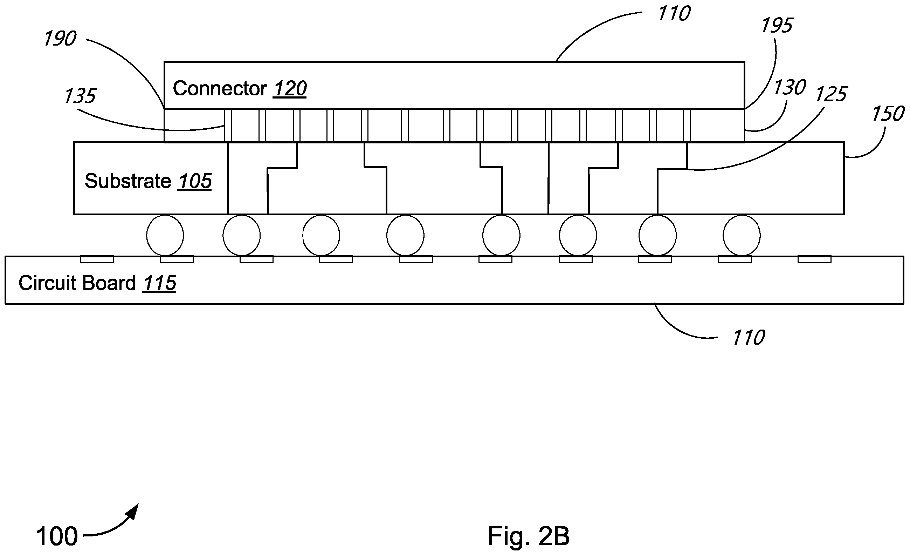

In some cases, the interconnects 125 extend through the substrate 105 or are coupled to a surface of the substrate 105. In a non-limiting example, as shown in FIG. 1A and FIG. 2B, traces 125a extend through the substrate 105 and are electrically coupled to solder balls 125b coupled to a surface of the substrate 105.

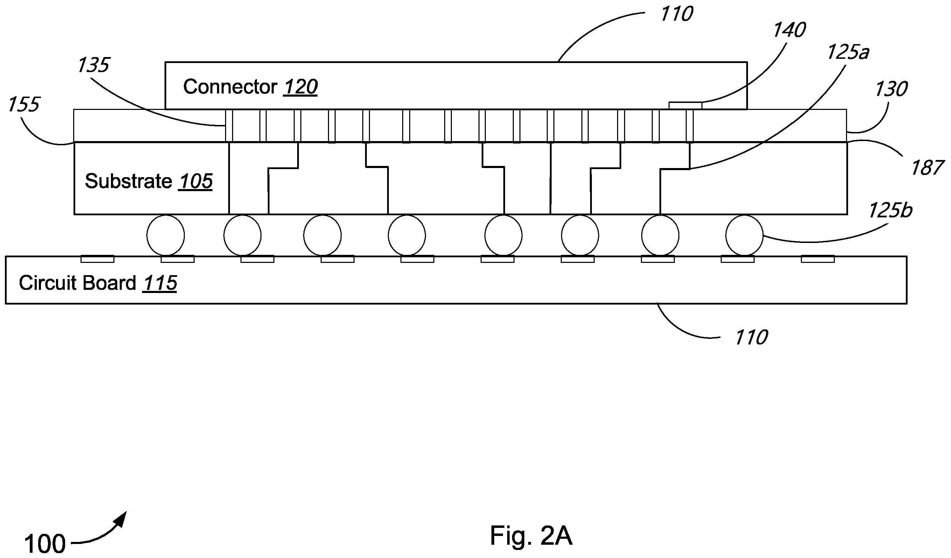

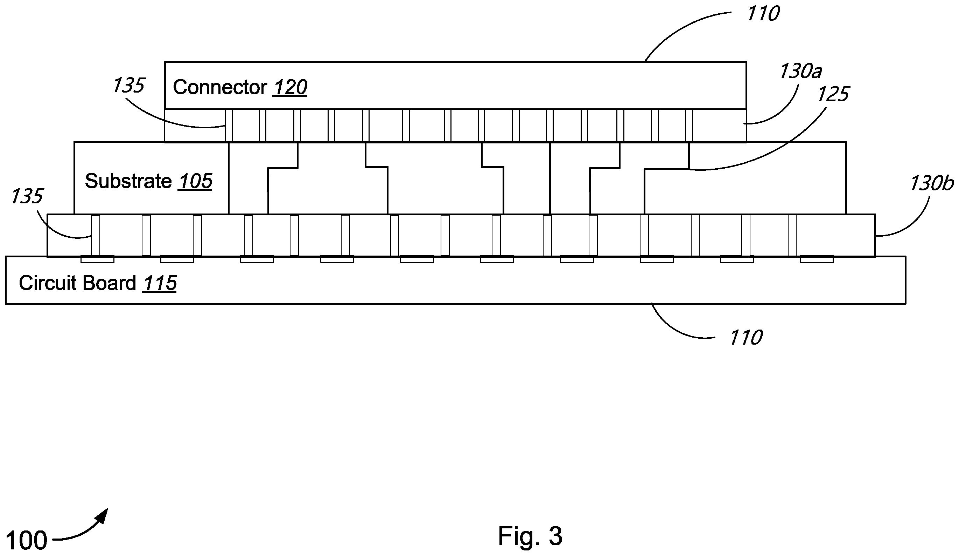

In various embodiments, the semiconductor device 100 further includes a member (e.g., a stiffener member, a stiffening member, a stiffener ring, a stiffening ring, or the like) 130. The stiffener member 130 is disposed between the substrate 105 and the connector 110. In the case of FIGS. 1A-1I, the member 130 is disposed between the substrate 105 and the printed circuit board 115. Alternatively, as shown in FIGS. 2A-2F, the member 130 is disposed between the substrate 105 and the connector(s) 120. Alternatively, as shown in FIGS. 3A, a first member 130a is disposed between the substrate 105 and the printed circuit board 115 and a second member 130b is disposed between the substrate 105 and the connector(s) 120.

The member 130 is configured to restrain to at least one of the substrate 105 or the connector 110. For example, in order to restrain at least one of the substrate 105 or the connector 110, the member 130 controls or prevents in-plane thermal expansion or contraction along a length of the substrate 105 or connector 110. In other words, the member 130 controls or prevents the spread or reduction of the substrate 105 or connector 110 along a length L5 or a width W3 of the substrate 105 or connector 110. Additionally, in order to restrain at least one of the substrate 105 or the connector 110, the member 130 controls or prevents out-of-plane (with respect to a plane extending along a length of the substrate) rotation of the substrate 105 or connector 110. In other words, the stiffener member 130 controls or prevents the substrate 105 or the connector 110 from curving or curling out-of-plane with respect to a plane extending along a length of the substrate. In some cases, the member 130 provides control of the out-of-plane warpage to the extent of halving the out-of-plane warpage of an equivalent stiffener-free semiconductor device. This control is vital to the practical use of a component (e.g., semiconductor device 100, substrate 105, or connector 110, or the like), where a high degree of flatness is required. For example, a high degree of flatness is required for conditions such as component electrical test and component assembly.

The member 130 may be in direct or indirect contact with the substrate 105 or the connector 110 to restrain at least one of the substrate 105 or the connector 110. By restraining at least one of the substrate 105 or the connector 110, the member 130 is configured to control or prevent the warpage or deformation of at least one of the substrate 105 or the connector 110. Warpage or deformation of at least one of the substrate 105 or the connector 110 may occur due to due to different construction materials used for the substrate 105 and the connector 110, due to a coefficient of thermal expansion mismatch between the substrate 105 and the connector 110, or the like. A semiconductor device that has warped or deformed more than a predetermined amount may be rendered useless because one or more interconnects 125 of the substrate 105 cannot connect to the one or more connectors 110. The member 130 works to restrain, prevent, or control at least one of substrate or connector from warping more than the predetermined amount and ensure that one or more interconnects 125 of the substrate 105 connect to the one or more connectors 110.

In some embodiments, the member 130 comprises one or more of a metal, ceramic, polymer, or any combination thereof. Even more specifically, the member 130 may comprise any combination of copper, aluminum, ceramic, steel, stainless steel, Teflon, silicon, or a polymer filled with silica or alumina, or the like.

The member 130 is configured to have about a same or similar coefficient of thermal expansion as the substrate 105. The coefficient of thermal expansion measures the fractional change in size of an object per degree change in temperature at a constant pressure (e.g., atmospheric pressure at sea level or other constant pressure). By forming the member 130 from a material having about the same or similar coefficient of thermal expansion as the substrate 105, the member 130 can have similar coefficient of thermal expansion properties (e.g., have similar expansion/contraction properties based on temperature) as the substrate. Having similar coefficient of thermal expansion properties between the substrate and the stiffener member helps to couple the member 130 to the substrate and further restrains the substrate 105 to reduce the warpage of the substrate 105 by helping control out-of-plane curling or curving of the substrate.

The member 130 can also restrain the substrate 105 based on the stiffness or Young's Modulus of the member 130. A higher stiffness or modulus would further restrain the substrate 105 or connector 110 to reduce the warpage of the substrate 105. The effectiveness of the member 130 to restrain the substrate 105 or the connector 110 are 1) its stiffness which is a function of the Young's modulus, 2) its geometry (x, y, z dimensions described below with respect to Figs. 1A-3) and 3) its coefficient of thermal expansion. Each of these properties act together to restrain the substrate 105 or the connector 110.

The member 130 additionally includes one or more vias 135. The one or more vias 135 may extend completely through a body 134 of the member 130 (e.g., a "through" via), may extend through a portion of the member 130 from one outer surface (e.g., a "blind" via), or may extend through a portion of the body 134 of the member 130 and be completely hidden from external view (e.g., a "buried" via), and/or the like. The one or more vias 135 might be filled, plated, or coated with an electrically conductive material. The electrically conductive material might include a metal such as copper, aluminum, gold, silver, tin, nickel, lead, or a combination of metals/alloys, or may be formed of other electrically conductive material or combination of electrically conductive materials. The one or more vias 135 are configured to form an electrical connection for an electrical signal to travel to or from the substrate 105 from or to the one or more connectors 110. In other words, the one or more vias 135 electrically couple the substrate 105 to the one or more connectors 110.

In some cases, as shown in FIG. 1A, the member 130 comprises at least two adjacent vias (e.g., vias 135a and 135b). A ratio between a distance D1 between an inside edge (or a center) of the at least two adjacent vias 135a and 135b and a width W1 of each via of the at least two adjacent vias 135a and 135b is at least 2:1. By having the ratio between a distance between the at least two adjacent vias and a width of each via of the at least two adjacent vias be at least 2:1, cross-talk between the adjacent vias is minimized while usage of space within the member 130 is maximized. In some cases, as shown in FIG. 1C, a ratio between a length L1 of the member 130 and a thickness T1 of the member 130 is equal or greater than 10:1. By making the member 130 as thin as possible, cross-talk between the adjacent vias is minimized while usage of space within the member 130 is maximized.

The one or more vias 135 may be electrically connected to the substrate 105, one or more connectors 110, and/or one or more interconnects 125 of the substrate 105 via one or more interconnects 140. The one or more interconnects 140 include, without limitation, one or more copper or metal pads, one or more copper or metal traces, one or more through-hole vias, micro bumps, one or more solder balls or bumps, one or more copper or metal posts or pillars, other suitable interconnects, combination of interconnects, or the like.

Now various embodiments of the member 130 will be described with respect to FIGS. 1-3. Although the member 130 of Figs. 1A-1F, 2A-2E, and 3 are described as separate embodiments for ease of description, a person of ordinary skill would understand that various modifications to the member 130 in each embodiment may be applied to other embodiments of the member 130.

Turning to FIG. 1A and 1B, the member 130 is a ring (e.g., rectangular, circular, triangular, etc.) with an opening 150. One or more interconnects 125c may be disposed in the opening 150 to electrically couple the circuit board 115 to the substrate 105. The member 130 is located between the substrate 105 and the circuit board 115. The member 130 extends along a length and width or a perimeter of the substrate 105 or circuit board 115 as shown in FIGS. 1A and 1B. When the member 130 is a ring, the member 130 applies restraint to a perimeter of the substrate 105 to prevent or control the warpage of the substrate 105. In the case of FIG. 1A, a first surface 155 of the member 130 pushes against a first surface 160 of the substrate 105 to prevent the substrate 105 from deforming or warping.

In FIGS. 1C-1F, the member 130 is a continuous layer with no openings except for the one or more vias 135. The member 130 has an area of a first surface 155 that is about or substantially a same area size (shown in FIG. 1C) or a larger area size (shown in FIG. 1E) as an area of a first surface 160 of the substrate 105 or a smaller area size (shown in FIG. 1F) as an area of a first surface 160 of the substrate 105. When the first surface 155 of the member 130 is about a same area size or a larger area size as an area of a first surface 160 of the substrate 105, the first surface 155 uniformly applies restraint across substantially an entire area of the first surface 160 of the substrate 105. As used herein, uniformly applying restraint means that the member 130 about evenly controls (1) in-plane thermal expansion of the substrate 105 or connector 110 and (2) out-of-plane rotation of the substrate 105 or connector 110 about substantially an entire area of the first surface 160 of the substrate. By uniformly applying restraint across the area of the first surface 160 of the substrate 105, the warpage or deformation of the substrate 105 may be prevented across the entire substrate 105 and not just at a perimeter of the substrate 105. In the case of FIG. 1C and 1E, a first surface 155 the member 130 pushes against a first surface 160 of the substrate 105 to prevent the substrate 105 from deforming or warping.

In some cases, as shown in FIG. 1E, the member 130 might have an area of a second surface 165 that is about or substantially a same area size as an area of a first surface 170 of the circuit board 115. When the second surface 165 of the member 130 is about a same area size or a larger area size as an area of a first surface 170 of the circuit board 115, the second surface 165 of the member 130 uniformly applies restraint across substantially an entire area of the first surface 170 of the circuit board 115. As used herein, uniformly applying restraint means that the member 130 about evenly controls (1) in-plane thermal expansion of the substrate 105 or connector 110 and (2) out-of-plane rotation of the substrate 105 or connector 110 about substantially an entire area of the first surface 170 of the circuit board 115. By uniformly applying restraint across the area of the first surface 170 of the circuit board 115, the warpage or deformation of the circuit board 115 may be prevented across the entire circuit board 115 and not just at a perimeter of the circuit board 115. In the case of FIG. 1C and 1E, a second surface 165 the member 130 pulls against a first surface 170 of the circuit board 115 to prevent the circuit board 115 from deforming or warping.

In some cases, as shown in FIG. 1F, the member 130 might have an area of a first surface 155 that is smaller than an area of a first surface 160 of the substrate 105. One or more interconnects 125 might be provided on an outer edge 157 of the member 130 between the circuit board 115 and the substrate 105.

In some embodiments, a length of the member 130 varies from the first surface 155 of the member 130 to the second surface 165 of the member 130. The length of the member 130 may vary based on a length L2 of the substrate and a length L3 of the circuit board 115. In a non-limiting example, as shown in FIG. 1G, if the substrate 105 is smaller than the circuit board 115, then a length L2 of the first surface 155 of the member 130 might be about a same length as a length L2 of the first surface 160 of the substrate 105 while a length L3 of the second surface 165 of the member 130 might be about a same length as a length L3 of the first surface 170 of the circuit board 115. Alternatively, if the substrate 105 is smaller than the circuit board 115, then a length of the first surface 155 of the member 130 might be about a same length as a length of the first surface 160 of the substrate 105 while a length of the second surface 165 of the member 130 might be about a same length as a length of the first surface 170 of the circuit board 115. In some cases, in order to vary the length of the member 130, the member 130 might include one or more sloped sidewalls 175. By varying the length of the member 130 based on the lengths of the substrate 105 and the circuit board 115, the first surface 155 of the member 130 uniformly applies restraint across substantially an entire area of the first surface 160 of the substrate 105 and the second surface 165 of the member 130 uniformly applies restraint across substantially an entire area of the first surface 170 of the circuit board 115.

As shown in FIG. 1H, one or more members 130 may be selectively placed at different locations between the substrate 105 and the circuit board 115. In a non-limiting example, the member 130 might be a ring 130c and have a portion 130d located towards a middle of the substrate 105, circuit board 115, the member 130b, or the like. One or more openings 180 between different portions of the member 130 might be used to add one or more additional connectors 110, interconnects 140, or other components.

In some cases, the member 130 is formed from one or more layers (e.g., layers 131, 132, and 133) as shown in FIG. 1I and 1J. The one or more layers might include a one or more redistribution layers 132 to route or reroute one or more electrical connections within the member 130 to different locations on the member 130. A redistribution layer 132 is needed when electrical connections within the substrate 105, member 130, and/or circuit board 115 are not aligned. In a non-limiting example, a redistribution layer 132 having one or more interconnects 185 within the member 130 may be used to connect one or more vias 135 at different locations of the member 130, as shown in FIG. 1I. Alternatively, a redistribution layer 132 having one or more interconnects 185 within the member 130 may be used to connect one or more vias 135 with one or more interconnects 125 of the substrate 105 or the circuit board 115, as shown in FIG. 1J.

Turning to FIG. 2A, the member 130 is located between a connector 120 and the substrate 105. In this case, the member 130 is a continuous layer with no openings except for the one or more vias 135. However, the member 130 could be a ring similar to the member 130 of FIGS. 1A and 1B. The member 130 might have an area of a first surface 155 that is about or substantially a same area size (shown in FIG. 2A) or a larger area size as an area of a second surface 187 of the substrate 105. When the first surface 155b of the member 130 is about a same area size or a larger area size as an area of a second surface 187 of the substrate 105, the first surface 155 uniformly applies restraint across substantially an entire area of the second surface 187 of the substrate 105. By uniformly applying restraint across the area of the second surface 187 of the substrate 105, the warpage or deformation of the substrate 105 may be prevented across the entire substrate 105 and not just at a perimeter of the substrate 105. In the case of FIG. 2A, the member 130 pulls a second surface 187 of the substrate 105 to prevent the substrate 105 from deforming or warping.

Turning to FIG. 2B, the member 130 is located between a connector 120 and the substrate 105. In this case, the member 130 is a continuous layer with no openings except for the one or more vias 135. The member 130 might have an area of a second surface 190 that is about or substantially a same area size (shown in FIG. 2A) or a larger area size as an area of a first surface 195 of the connector 120. When the second surface 190 of the member 130 is about a same area size or a larger area size as an area of a first surface 195 of the connector 120, the second surface 190 uniformly applies restraint across substantially an entire area of the first surface 195 of the connector 120. By uniformly applying restraint across the area of the first surface 195 of the connector 120, the warpage or deformation of the connector 120 may be prevented across the entire substrate 105 and not just at a perimeter of the connector 120. In some cases, similar to FIG. 1F, the length of the member may vary based on a length of the substrate 105 and the connector 120.

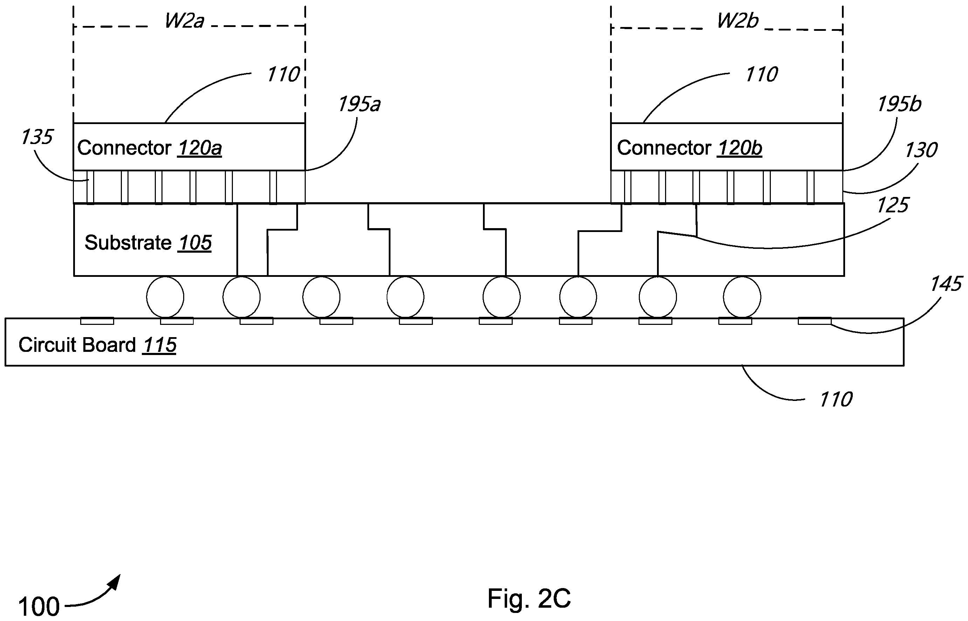

In some cases, as shown in FIG. 2C, there are two or more connectors 120 (e.g., connectors 120a and 120b) and the member 130 is provided between the two or more connectors 120a and 120b and the substrate 105. In the case of FIG. 2C, the member 130 is a ring. A width W2a and W2b of the member 130 might vary based on a first surface (e.g., first surface 195a and 195b) of a connector 120 (e.g., connectors 120a and 120b). In a non-limiting example, a width W2a of a first side of the member 130 is about a same width as a first surface 195a of the connector 120a while a width W2b of a second side opposite the first side of the member 130 is about a same width as a first surface 195b of the connector 120b. Width W2a and width W2a may be a same width or a different width depending on the widths of the first surfaces 195a and 195b of the connector 120.

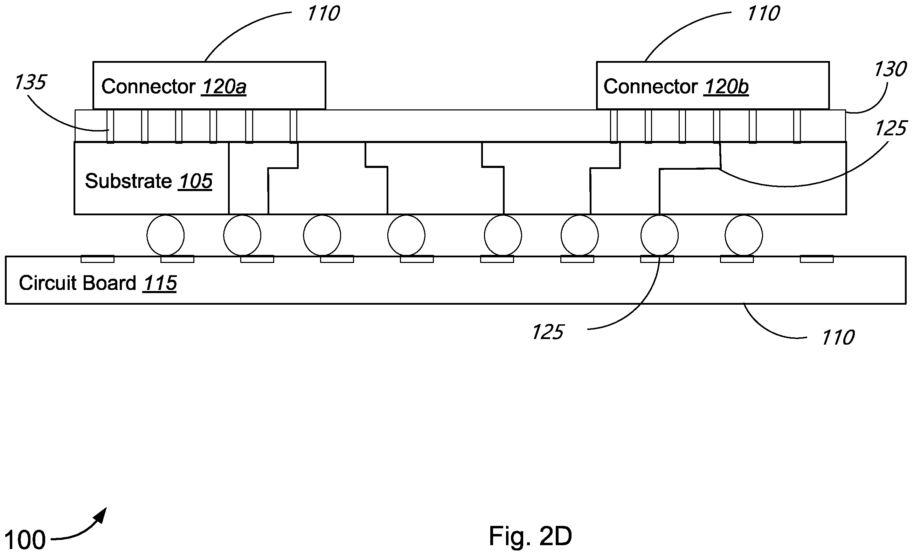

In FIG. 2D, the member 130 is a continuous layer with no openings except for the one or more vias 135. The member 130 is provided between two or more connectors 120 (e.g., connectors 120a and 120b). The one or more vias 135 are selectively provided in locations where there are one or more connectors 120 and are not provided in locations where there are no connectors 120.

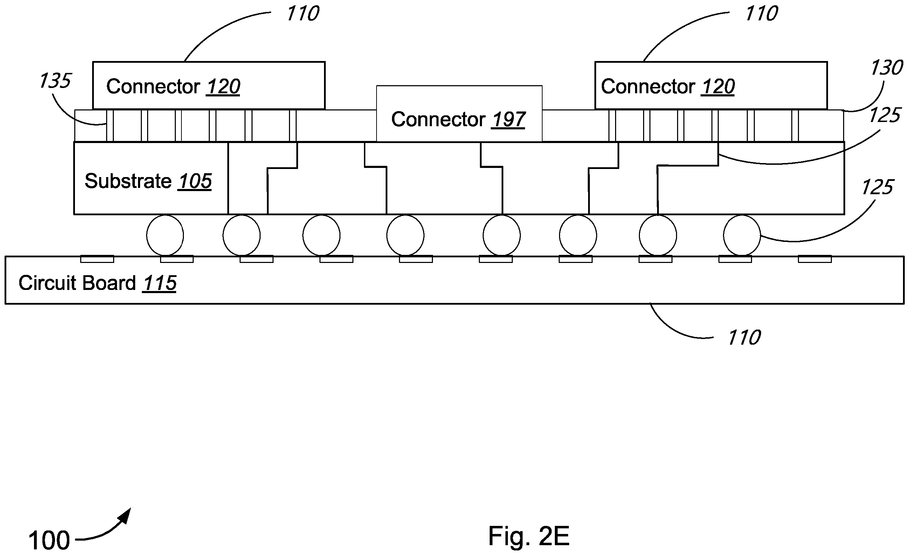

As shown in FIG. 2E, the member 130 might have one or more openings selectively provided on the member 130. The one or more openings between different portions of the member 130 might be configured to surround one or more additional connectors 197, interconnects, or other components.

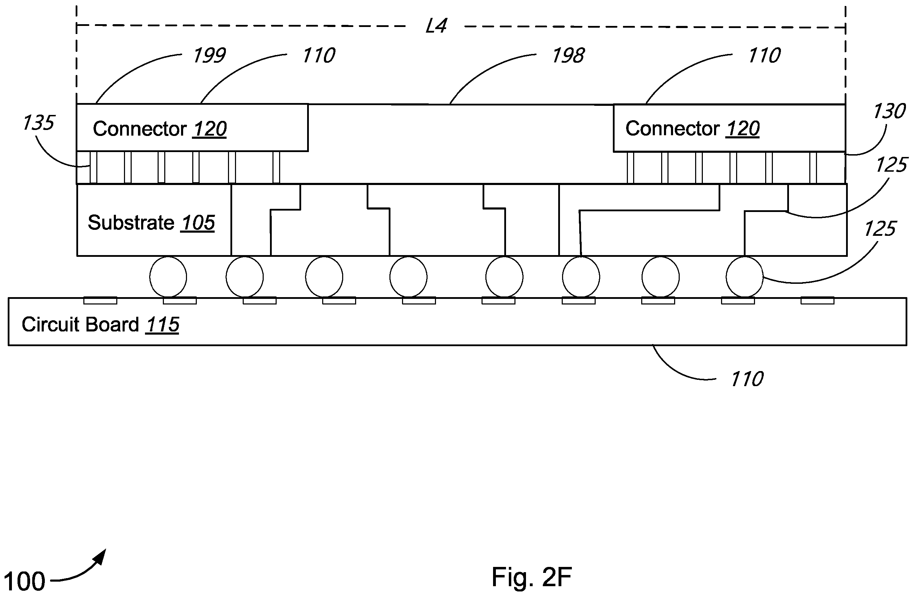

In various embodiments, as shown in FIG. 2F, the thickness of the member 130 may vary across a length L4 of the member 130. In a non-limiting example, the member 130 might be thicker or thinner in a middle portion 198 of the member 130. In some cases, the thickness of the middle portion 198 of the member 130 might be configured to be about flush or uniform with a second surface 199 of at least one of the one or more connectors 120.

Turning to FIG. 3, two members 130a and 130b might be provided. A first member 130 is located between the substrate and the circuit board 115 while a second member 130b is located between the substrate and the one or more connectors 120.

It should be noted that although the member 130 of Figs. 1A-1J, 2A-2F, and 3 are described as separate embodiments for ease of description, a person of ordinary skill would understand that various modifications to the member 130 in each embodiment may be applied to other embodiments of the member 130. In a non-limiting example, the member 130 between the substrate 105 and the connector 120 may also have one or more redistribution layers similar to the embodiments described in FIGS. 1I and 1J. Additionally, although the member 130 is depicted as comprising a substantially rectangular or square cross-section, it should be appreciated that any shape or combination of shapes may be used for the member 130. In some non-limiting examples, the member 130 may comprise a tube shape (e.g., circular or elliptical cross section), a polygonal cross section, a triangular cross section, or the like.

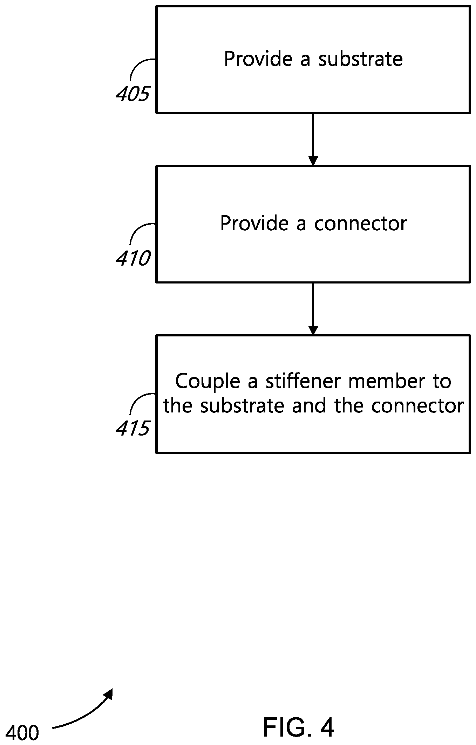

Fig. 4 is a flow diagram of a method 400 of manufacturing a semiconductor device 100, in accordance with various embodiments. The method 400 may begin, at block 405, by providing or forming a substrate. Forming the substrate may include, without limitation, various additive and/or subtractive manufacturing processes, as known to those skilled in the art. In further examples, manufacturing techniques that are being developed and/or yet to be developed may be utilized to form the substrate. Thus, it is to be understood that the method 400 is not limited to any particular method of manufacturing a particular substrate.

The method 400 continues, at block 410, by providing or forming a connector. The connector may comprise at least one of a circuit board, optical connector, a high-speed data connector, a high-power connector, or a backplane connector, or the like.

The method 400 continues, at block 415, by coupling a stiffening member to the substrate and the connector. The member is between the substrate and connector. The member includes one or more vias. The one or more vias extend through the member and electrically couple the substrate to the connector.

The techniques and processes described above with respect to various embodiments may be used to manufacture the semiconductor devices 100 of FIGS. 1-3, and/or components thereof, as described herein.

While some features and aspects have been described with respect to the embodiments, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. An apparatus (100) comprising:
a substrate (105);
a connector (110) coupled to the substrate (105); and
a member (130) disposed between the substrate (105) and the connector (110) and configured to restrain at least one of the substrate (105) or the connector (110), the member (130) comprising a via (135), the via (135) being coupled to the connector (110) and to the substrate (105).

2. The apparatus (100) of claim 1, wherein an area of a first surface of the member (130) adjacent to a first surface (160) of the substrate (105) is **characterized by** about a same area size as an area of the first surface (160) of the substrate (105).

3. The apparatus (100) of claim 1 or 2, wherein the member (130) is configured to uniformly restrain the substrate (105) across the area of the first surface (160) of the substrate (105).

4. The apparatus (100) of any of claims 1 to 3, wherein an area of a first surface of the member (130) adjacent to a first surface (160) of the substrate (105) is smaller than a second surface of the member (130) adjacent to a first surface of the connector (110).

5. The apparatus (100) of any of claims 1 to 4, wherein the connector (110) comprises a printed circuit board.

6. The apparatus (100) of claim 5, wherein an area of a second surface of the member (130) adjacent to a first surface of the printed circuit board is **characterized by** about a same area size as an area of the first surface of the printed circuit board.

7. The apparatus (100) of any of claims 1 to 6, wherein the connector (110) comprises at least one of an optical connector, a high-speed data connector, a high-power connector, or a backplane connector.

8. The apparatus (100) of claim 7, wherein an area of a second surface of the member (130) adjacent to a first surface of the connector (110) is **characterized by** about a same area size or larger area size as an area of the first surface of the connector (110).

9. The apparatus (100) of any of claims 1 to 8, comprising at least one of the following features:
wherein the member (130) has a about a same coefficient of thermal expansion as the substrate (105);
wherein the member (130) comprises at least two adjacent vias (135), and wherein a ratio between a distance between the at least two adjacent vias (135) and a width of each via (135) of the at least two adjacent vias (135) is at least 2:1;
wherein a ratio between a length of the member (130) and a thickness of the member (130) is equal or greater than 10:1;
wherein the member (130) comprises at least one of copper, aluminum, ceramic, steel, stainless steel, Teflon, silicon, or polymer, and wherein the via (135) comprises at least one of copper, aluminum, gold, silver, tin, nickel, or lead.

10. A semiconductor device (100) comprising:
a substrate (105) comprising an interconnect;
a connector (110) configured to couple to the interconnect of the substrate (105); and
a member (130) between the substrate (105) and the connector (110) and configured to restrain at least one of the substrate (105) or the connector (110), the member (130) comprising a via (135) coupling the interconnect of the substrate (105) to the connector (110).

11. The semiconductor device (100) of claim 10, comprising at least one of the following features:
wherein a first surface of the member (130) adjacent to a first surface (160) of the substrate (105) uniformly restrains the substrate (105) across the first surface (160) of the substrate (105);
wherein an area of a first surface of the member (130) adjacent to a first surface (160) of the substrate (105) is larger than an area of the first surface (160) of the substrate (105).

12. The semiconductor device (100) of claim 10 or 11, wherein the connector (110) comprises a printed circuit board.

13. The semiconductor device (100) of claim 12, wherein a second surface of the member (130) adjacent to a first surface (160) of the printed circuit board uniformly restrains the printed circuit board across the first surface of the printed circuit board.

14. The semiconductor device (100) of any of claims 10 to 13, comprising at least one of the following features:
wherein the connector (110) comprises at least one of an optical connector, a high-speed data connector, a high-power connector, or a backplane connector;
wherein the via (135) is located in a first layer of the member (130), and the member (130) further comprises a second redistribution layer electrically coupled to the via (135).

15. A method comprising:
providing a substrate (105);
providing a connector (110); and
coupling a member (130) to the substrate (105) and the connector (110), the member (130) configured to restrain at least one of the substrate (105) or the connector (110), wherein the member (130) is between the substrate (105) and the connector (110) and comprises a via (135), the via (135) being coupled to the connector (110) and to the substrate (105).
